**Europäisches Patentamt**

**European Patent Office**

**Office européen des brevets**

(19)

(11) Veröffentlichungsnummer: **0 055 303**
**B1**

(12) **EUROPÄISCHE PATENTSCHRIFT**

(45) Veröffentlichungstag der Patentschrift: **03.04.85**

(51) Int. Cl.⁴: **G 03 F 9/00, G 03 F 1/00**

(21) Anmeldenummer: **80108233.0**

(22) Anmeldetag: **29.12.80**

(54) **Maske zur Abbildung eines Musters auf einer Photoresistschicht, Verfahren zur Herstellung dieser Maske und Verwendung derselben in einem photolithographischen Prozess.**

(43) Veröffentlichungstag der Anmeldung:
**07.07.82 Patentblatt 82/27**

(45) Bekanntmachung des Hinweises auf die
Patenterteilung:
**03.04.85 Patentblatt 85/14**

(84) Benannte Vertragsstaaten:
**DE FR GB**

(56) Entgegenhaltungen:
**US-A-3 771 872**

**IBM TECHNICAL DISCLOSURE BULLETIN,
Band 20, Nr. 7, Dezember 1977, Seiten 2682-
2684 New York, U.S.A. H.R. ROTTMANN et al.:
"Accurate two dimensional measurement of
overlays"**

(73) Patentinhaber: **IBM DEUTSCHLAND GMBH
Pascalstrasse 100
D-7000 Stuttgart 80 (DE)**
(84) **DE**

(73) Patentinhaber: **International Business Machines
Corporation
Old Orchard Road
Armonk, N.Y. 10504 (US)**
(84) **FR-GB**

(72) Erfinder: **Schwarzbach, Frank Axel
Theodor-Heuss-Strasse 11
D-7031 Hildrizhausen (DE)**
Erfinder: **Kolbe, Hartmut
Amsterdamer Strasse 40
D-7030 Böblingen (DE)**

(74) Vertreter: **Kreidler, Eva-Maria, Dr. rer. nat.
Schönaicher Strasse 220
D-7030 Böblingen (DE)**

Courier Press, Leamington Spa, England.

## Beschreibung

Die Erfindung betrifft eine Maske zur Abbildung eines Musters, das aus mehreren Chipfeldern zusammengesetzt ist, auf einer Photoresistschicht, mit mindestens einer Justiermarke zwischen mindestens zwei benachbarten Chipfeldern, eine Verfahren zur Herstellung dieser Maske und die Verwendung von Masken dieser Art in einem photolithographischen Prozeß.

Die Komplexität integrierter Schaltkreise hat in der Vergangenheit exponentiell zugenommen. So wurden, ausgehend von Einzelschaltungen integrierte Schaltkreise mit kleiner, mittlerer und großer Schaltkreisdichte und schließlich integrierte Schaltkreise mit sehr großer Schaltkreisdichte (VLSIs) mit bis zu 100 000 Transistoren pro Chip hergestellt. Diese Komplexität der Schaltkreise bringt viele Herstellungsprobleme mit sich, die zu lösen sind. Ein wesentliches Problem liegt auf dem Gebiet der Mikrolithographie, d.h. der Entwicklung von Methoden zur Abbildung dieser dichten Schaltkreisstrukturen auf der Unterlage oder dem Wafer.

Zur Herstellung von LSI-Schaltkreisen werden als Werkzeuge Masken, die normalerweise aus einem dünnen Glasträger mit einem noch dünneren Überzug aus Chrom bestehen, verwendet. Die Chrommaske definiert die gewünschten Schaltkreisstrukturen einer Schicht, die in einem bestimmten Prozeßschritt hergestellt werden. Beispielsweise definiert die Maske einen Bereich, der durch Ätzen aus dem Wafer entfernt werden soll. Nachdem alle Prozeßschritte zu Ende geführt sind, jeder einzelne mit seiner eigenen Maske, werden die Wafer entlang der Schnittfugen geschnitten und die einzelnen Chips auf Unterlagen, sogenannten Moduln, befestigt.

Die Masken, die bei den einzelnen Prozeßschritten verwendet werden, müssen mit höchster Genauigkeit hergestellt werden, denn die mit ihnen hergestellten Halbleitervorrichtungen können nicht besser als die Werkzeuge (Masken) sein, die zu ihrer Herstellung verwendet werden.

Früher wurden bei der Herstellung von Masken, bei denen sich das gleiche Muster schrittweise wiederholt, entsprechend der schrittweisen Wiederholung der Chips, auf dem Wafer zwei auf entgegengesetzten Seiten der Masken liegende Chipplätze ausgespart und Justiermarken im Zentrum dieser Chipplätze angeordnet. Nachteilig an diesem Verfahren ist, daß pro Wafer zwei Chips weniger hergestellt werden können, was insgesamt zu einer Erniedrigung der Ausbeute führt. Man hat auch bereits Justiermarken in den Bereichen der Maske angeordnet, die den Schnittfugen auf dem Halbleiterwafer entsprechen. Es hat sich jedoch gezeigt, daß diese Justiermarken durch die bei der Maskenherstellung auftretenden Fehler und Verzerrungen nachteilig beeinflußt werden und dadurch die Masken der einzelnen Prozeßschritte in den gewünschten Strukturen nicht ausreichend zur Deckung gebracht werden können.

Aus der US—Patentschrift 3 771 872 ist eine Maske bekannt, auf der eine Justiermarke gebildet wird aus einer Vielzahl sehr kleiner Elemente, die sich in diagonaler Richtung zur Hauptlinie der Justiermarke erstrecken und so angeordnet sind, daß die Brechungseffekte an den Kanten der Elemente in der Weise zusammenwirken, daß ein einziges dichtes Bild entsteht. Die Justiermarken können jedes Element auf einer Halbleitervorrichtung umrahmen.

Aufgabe der Erfindung ist die Bereitstellung einer Maske und ein Verfahren zur Herstellung dieser Maske mit Justiermarken, mit denen eine genauere Ausrichtung der Maske als mit den bisherigen Justiermarken möglich ist, die wegen der bei ihrer Herstellung auftretenden Verzerrungen zu Fehljustagen führen.

Die Aufgabe der Erfindung wird gelöst durch eine Maske mit mindestens einer Justiermarke zwischen mindestens zwei benachbarten Chipfeldern, die dadurch gekennzeichnet ist, daß am Rande dieser benachbarten Chipfelder Plätze für Justiermarken vorgesehen sind, die sich bei idealem Aufbringen der Chipfeldmuster auf die Maske decken würden, und daß die Justiermarke der Maske durch die Überlagerungsfläche der vorgesehenen Justiermarkenplätze gebildet wird und dadurch die Mittelung der Positionsfehler der beteiligten Chipfelder darstellt.

Gegenstand der Erfindung ist auch ein Verfahren zur Herstellung dieser Masken und deren Verwendung in einem photolithographischen Prozeß bei der Herstellung von Halbleiterbauelementen.

Die Justiermarken der erfindungsgemäßen Maske werden durch geometrisch-photochemische Mittelung aus mindestens zwei Justiermarken zwischen mindestens zwei benachbarten Chipfeldern erhalten, wodurch Vergrößerungs- und Verzerrungsfehler bei der Herstellung der Maske weitgehend ausgeschaltet werden können. Ausrichtfehler, die aus der schrittweisen Bewegung des Tisches resultieren, können durch die Mittelung zumindest teilweise eliminiert werden. Darüber hinaus ist für die Justiermarke, die durch Überlagerung von Justiermarkenplätzen gebildet wird, keine Fläche über die für die Einzelmarke hinaus erforderlich. Die Erfindung wird anhand der Figuren und der Beschreibung näher erläutert.

Es zeigen:

Fig. 1 ein Fließschema zur Herstellung von Masken.

Fig. 2 einen Ausschnitt aus dem Feld einer Maske mit den wichtigsten Maskenfehlern.

Fig. 3A eine Maske, bei der zwei Justiermarken auf der Schnittfuge zweier auf entgegengesetzten Seiten der Masken liegender Chips angeordnet sind.

Fig. 3B ein Ausschnitt zweier Chipfelder aus Fig. 3A mit einer Justiermarke, die durch Mittelung der den Chipfeldern zugeordneten beiden Marken entstanden ist.

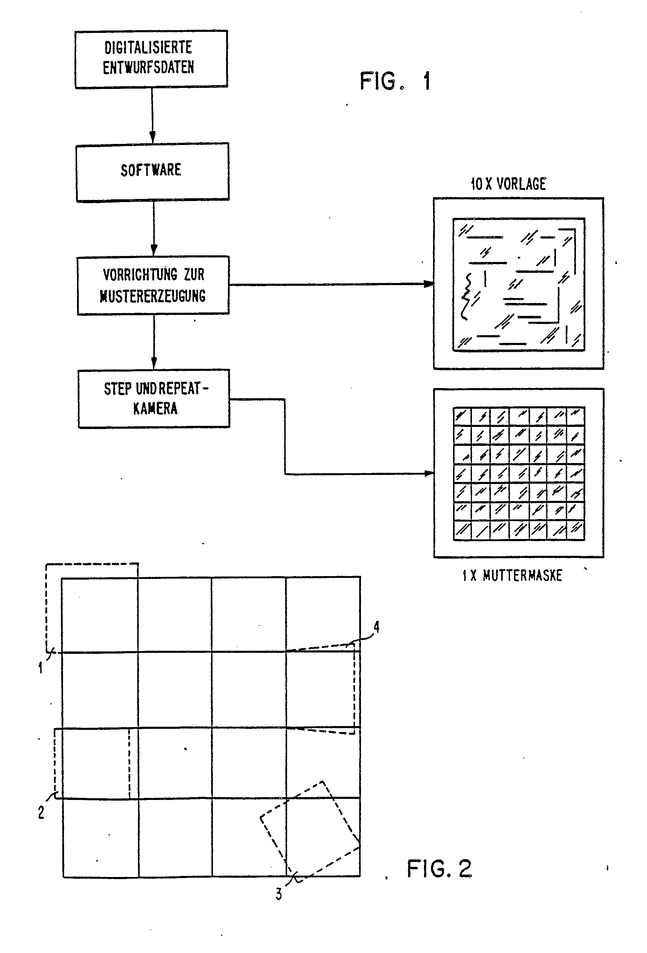

Nach dem konventionellen optischen Verfahren zur Maskenherstellung, das in Fig. 1 dargestellt ist, erstellt ein Designer den Entwurf des gewünschten integrierten Schaltkreises. Die digitalisierten Entwurfsdaten werden mit Hilfe der Software in Maschinenbefehle umgesetzt. Mit diesen Programmdaten wird eine Vorrichtung zur Mustererzeugung gesteuert.

Bei diesem Verfahren wird die Vorlage von mindestens einem Chip für einen Prozeßschritt in zehnfacher Vergrößerung hergestellt. Da für die Belichtung von Wafern Masken benötigt werden, bei denen sich dieses Chipmuster schrittweise wiederholt, wird eine Vervielfachung des Musters der Vorlage mit der Step- und Repeatkamera ausgeführt. Hierzu wird die Vorlage genau justiert. Die Kamera bildet die Vorlage 10:1 verkleinert auf eine Photoplatte ab, die sich in einem Halter befindet, der mit konstanter Geschwindigkeit in X-Richtung bewegt wird. Die Wegstrecke dieses Halters wird anhand von elektrischen Impulsen die von einer Steuereinheit gezählt werden, bestimmt. Nach einer bestimmten Anzahl gezählter Impulse wird die Vorlage auf die Photoplatte projiziert. Der gleiche Vorgang wird periodisch wiederholt, bis eine Zeile aus beispielsweise 10 Belichtungen vollendet ist. Dann rückt die Photoplatte um einen Chipabstand in Y-Richtung weiter, und die Belichtungen der nächsten Zeile in X-Richtung werden vorgenommen. Der Vorgang wird solange wiederholt, bis alle Belichtungen zur Herstellung der 1X Muttermaske ausgeführt sind. Wesentlich ist, daß die Belichtungen der einzelnen Felder auf der Maske, die den Chipfeldern auf dem Wafer entsprechen, in der Weise vorgenommen werden, daß die Justiermarken, die in jeder Reihe der Chipfelder im Bereich der späteren Schnittfugen des Wafers angeordnet sind, von den Justiermarken der benachbarten Reihe der Chipfelder überlagert werden. Bei der nachfolgenden Entwicklung der so belichteten Photoresistschicht werden Justiermarken gebildet, die das Mittel aus Marken benachbarter Chipfelder darstellen. Die 1X Muttermaske wird fertiggestellt, indem die belichtete Platte in konventioneller Weise entwickelt und die unter der Photoresistmaske liegende Chromschicht geätzt wird.

In Fig. 2 sind die wichtigsten optisch-mechanischen Verzerrungen der Maske, die bei einem Herstellungsverfahren mit optischer Belichtung auftreten können und zu einer Fehljustierung zwischen den einzelnen Masken in einem Maskensatz führen können, dargestellt.

Bei Maskenfehlern unterscheidet man zwischen Unregelmäßigkeiten im Chipfeld und Unregelmäßigkeiten, die von Chipfeld zu Chipfeld auftreten. Zu den ersteren zählen Fehler bei der Herstellung der 10X-Vorlage und Fehler, die bei der Ausrichtung dieser 10X-Vorlage auf die Muttermaske und außerdem Fehler, die durch die Übertragung im Verhältnis 10:1 auf die Muttermaske zustandekommen, beispielsweise solche, die auf Fokussierungseinflüsse und dgl. zurückzuführen sind.

Die zweite Gruppe der Unregelmäßigkeiten von Chipfeld zu Chipfeld umfaßt beispielsweise Bewegungsungenauigkeiten im Tisch und im Tischantrieb, wobei zwischen Fehlern erster Ordnung, sog. Stepfehlern in X- und Y-Richtung und Fehlern zweiter Ordnung, bei denen die 10X-Vorlage nicht genau parallel zur Tischbewegung ausgerichtet, d.h. eine Neigung zur optischen Ebene vorhanden ist, zu unterscheiden ist. Außer den Justagefehlern im photolithographischen Belichtungssystem können unebene Masken, Temperatureffekte und dgl. zu weiteren Maskenfehlern führen.

In Abbild. 2 ist unter 1 ein Fehler dargestellt, der durch die Verkleinerung der Vorlage im Verhältnis 10:1 auf das Maskenfeld zustandekommt (Fokussierungseinfluß). Unter 4 ist ein Fehler dargestellt, der bei nichtparalleler Anordnung der Vorlage zum Tisch im Chipfeld auftritt. Unter 3 ist die Rotation eines Chipfeldes dargestellt. Als Beispiel für Unregelmäßigkeiten von Chipfeld zu Chipfeld ist unter 2 die seitliche Versetzung eines Chipfeldes durch einen Stepfehler dargestellt. Nicht dargestellt sind beispielsweise tonnenförmige und kissenförmige Verzeichnungen, die durch einen Linsenfehler im Chipfeld auftreten und keilförmige Verzerrungen in der Maske, die durch fehlende Parallelität zwischen Vorlage und Maske und unterschiedliche thermische Koeffizienten von Maske zu Vorlage zustandekommen. Bei den derzeit nach dem Stand der Technik herstellbaren hochwertigen Masken fallen Fehler im Chipfeld (1, 3, 4 in Fig. 2) in etwa gleichem Maße ins Gewicht, wie Fehler der Tischbewegung (2 in Fig. 2), die bei der Herstellung der Muttermaske durch Ablichten der 10X-Vorlage entstehen.

Es ist bekannt, daß weitere maschinenmäßige Verbesserungen in Bereiche der Präzisionsmechanik nicht mehr möglich sind. Eine Verbesserung der Maskenherstellung kann deshalb nur noch durch Verbesserungen im Bereiche der Photolithographie erfolgen. Gegenstand der vorliegenden Erfindung ist eine Verbesserung in letzterem. Bei dem erfindungsgemäßen Verfahren zur Herstellung einer Maske erfolgt eine photochemische Überlagerung der abzubildenden Chipfelder in der Schnittfuge an der Peripherie der einzelnen Felder, d.h. in einem Teilbereich, in dem sich die Justiermarken befinden. Bei diesem Verfahren werden Vergrößerungs- Verzerrungs- und Kippfehler eliminiert und Ausrichtfehler, die aus der schrittweisen Bewegung des Tisches resultieren, durch die Mittelung zumindest teilweise eliminiert.

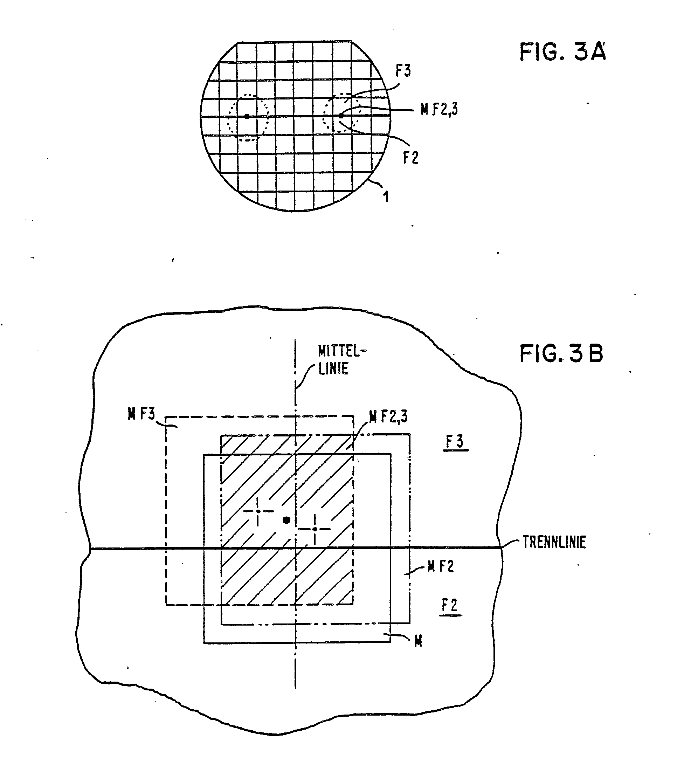

In Fig. 3A ist eine 1X Muttermaske 1 dargestellt, bei der zwei benachbarte Chipfelder F2 und F3 durch Umrandung hervorgehoben sind. Die Justiermarke auf der Schnittfuge zwischen diesen beiden Feldern, die durch Mittelung aus den Marken der Felder 2 und 3 entstanden ist, ist mit M F2,3 bezeichnet. Aus Fig. 3B ist ersichtlich, wie die Justiermarke M F2,3 durch Mittelung aus den Marken der Felder 2 und 3 entstanden ist.

In Fig. 3B stellt die dort eingezeichnete Trennlinie die Schnittfuge zwischen den zwei benachbarten Chipfeldern F2 und F3 dar. Bei idealen Verhältnissen liegt der Schwerpunkt der Justiermarke M, die durch Überlagerung der Justiermarken der Felder F2 und F3 zustandekommt, genau auf dem Schnittpunkt der Mittellinie der Chipfelder mit der Schnittfuge oder Trennlinie. In einem Fall aus der Praxis ist die Justiermarke M F2 nach oben und seitlich nach rechts verschoben, die Justiermarke M F3 ist entsprechend der Darstellung nach oben und seitlich nach links verschoben. Die Schwerpunkte beider Justiermarken sind in der Abbildung links und rechts der Mittellinie angegeben.

Das in Fig. 3B angegebene schraffierte Feld, das mit M F2,3 bezeichnet ist und durch Überlagerung der entsprechenden Bereiche der Justiermarkenfelder M F2 und M F3 gebildet wird, ist die Justiermarke, die dem Operator später zur Justierung der Maske auf den Halbleiterwafer zur Verfügung steht. Der Schwerpunkt dieses Feldes liegt auf der Verbindungslinie der Schwerpunkte der Felder M F2 und M F3, in der Abbildung links in unmittelbarer Nähe der Mittellinie.

Die in den Fign. 3A und 3B gezeigte Ausführung der gemittelten Justiermarken stellt die einfachste Ausführungsform dar. In diesem Fall liegt die Justiermarke im Bereich des Schnittpunktes der Schnittfuge oder Trennlinie mit der Mittellinie der Chipfelder. Die Justiermarken können jedoch auch in den Ecken der Chipfelder angeordnet werden. Bei einer Anordnung dieser Art wird durch photochemische Überlagerung eine Justiermarke erhalten, die das Mittel aus vier Justiermarken benachbarter Chipfelder darstellt. Durch die vierfache Überlagerung der Justiermarken ist eine noch günstigere Beeinflussung der Fehlerkomponenten möglich als bei Überlagerung von zwei Marken. Es sind weitere Ausführungsformen der Erfindung mit photochemischer Überlagerung von Justiermarken denkbar, die im Bereich der vorliegenden Erfindung liegen.

Mit dem Verfahren der vorliegenden Erfindung ist es möglich besser justierbare Maskensätze für Halbleiterprozesse bereitzustellen, die eine höhere Integration durch bessere Strukturüberlagerung der einzelnen Prozeßschritte ermöglichen. Im Halbleiterprozeß werden wegen der höheren Genauigkeit, mit der die Masken justiert werden können, weniger parasitäre Elemente gebildet, und die Produktausbeute und Zuverlässigkeit der integrierten Schaltungen wird erhöht.

## Patentansprüche

1. Maske zur Abbildung eines Musters, das aus mehreren Chipfeldern zusammengesetzt ist, auf einer Photoresistschicht, mit mindestens einer Justiermarke zwischen mindestens zwei benachbarten Chipfeldern, dadurch gekennzeichnet, daß am Rand dieser benachbarten Chipfelder Plätze für Justiermarken vorgesehen sind, die sich bei idealem Aufbringen der Chipfeldmuster auf die Maske decken würden, und daß die Justiermarke der Maske durch die Überlagerungsfläche der vorgesehenen Justiermarkenplätze gebildet wird und dadurch die Mittelung der Positionsfehler der beteiligten Chipfelder darstellt.

2. Maske nach Anspruch 1, dadurch gekennzeichnet, daß die Justiermarke in dem Bereich der Maske, der den Schnittfugen auf dem Halbleiterwafer entspricht, angeordnet ist.

3. Maske nach den Ansprüchen 1 und 2, dadurch gekennzeichnet, daß die Justiermarke im Bereich des Schnittpunkts der Schnittfuge mit der Mittellinie der Chipfelder angeordnet ist.

4. Maske nach den Ansprüchen 1 und 2, dadurch gekennzeichnet, daß die Justiermarke im Bereich der Schnittfugen in dern Ecken der einzelnen Chipfelder angeordnet ist.

5. Maske nach den Ansprüchen 1 bis 4, dadurch gekennzeichnet, daß sie aus einer Vielzahl identischer Chipfelder besteht.

6. Maske nach einem oder mehreren der Ansprüche 1 bis 5, dadurch gekennzeichnet, daß sie aus Chrom besteht.

7. Verfahren zur Herstellung einer Maske nach den Ansprüchen 1 bis 6, dadurch gekennzeichnet, daß eine Vorlage mit dem Muster des gewünschten Chipfeldes und der darauf vorgesehenen Justiermarken mit n-facher Verkleinerung periodisch auf ein Glasplatte, auf der eine Chrom- und eine Photoresistschicht angeordnet sind, abgebildet wird, die Photoresistschicht entwickelt und die Chromschicht durch die Photoresistmaske geätzt wird.

8. Verfahren nach Anspruch 7, dadurch gekennzeichnet, daß die Photochemische Belichtung der Vorlage in der Weise erfolgt, daß den Justiermarken der einen Reihe der Chipfelder die Justiermarken der Folgereihe der Chipfelder überlagert werden und Justiermarken als Mittel aus mindestens zwei Belichtungen gebildet werden.

9. Verfahren nach den Ansprüchen 7 und 8, dadurch gekennzeichnet, daß die Justiermarken in dem Bereich der Maske, der der Schnittfuge auf dem Halbleiterwafer entspricht, abgebildet werden.

10. Verwendung von Masken mit Justiermarken, die nach den Ansprüchen 7 bis 9 hergestellt wurden in einem photolithographischen Prozeß zur Herstellung von Halbleiterbauelementen.

## Revendications

1. Masque pour la reproduction d'un dessin qui est composé de plusieurs surfaces de pastilles, sur une couche de laque photosensible, muni d'au moins une marque de repérage située entre au moins deux surfaces de pastilles voisines, caractérisé en ce que, le long du bord de ces surfaces de pastilles voisines, sont prévus des emplacements pour les marques de repérage, qui se superposeraient mutuellement dans le cas d'un report parfait des dessins de surfaces de pastilles sur le masque et en ce que la marque de repérage du masque est formée par la surface de recouvrement des emplacements de marques de repérage prévus et, de cette façon, représente la moyenne des erreurs de position des surfaces de pastilles intéressées.

2. Masque selon la revendication 1, caractérisé en ce que la marque de repérage est disposée dans la région du masque qui correspond aux lignes de découpage sur la tranche de semi-conducteur.

3. Masque selon les revendications 1 et 2, caractérisé en ce que la marque de repérage est placée dans la région du point d'intersection entre les lignes de coupe et la médiane des surfaces de pastilles.

4. Masque selon les revendications 1 et 2, caractérisé en ce que la marque de repérage est disposée dans la région des lignes de découpage, aux angles des différentes surfaces de pastilles.

5. Masque selon les revendications 1 à 4, caractérisé en ce qu'il est composé d'un grand nombre de surfaces de pastilles identiques.

6. Masque selon une ou plusieurs des revendications 1 à 5, caractérisé en ce qu'il est réalisé en chrome.

7. Procédé de fabrication d'un masque selon les revendications 1 à 6, caractérisé en ce qu'on reproduit périodiquement l'image d'un original portant le dessin de la surface de pastille désirée et des marques de repérage prévues sur ce dessin, avec une réduction de $n$ fois, sur une plaque de verre sur laquelle sont déposées une couche de chrome et une couche de laque photosensible, on développe la couche de laque photosensible et on attaque la couche de chrome à travers le masque de laque photosensible.

8. Procédé selon la revendication 7, caractérisé en ce que l'exposition photochimique de l'original est réalisée de telle manière qu'aux marques de répérage de l'une des rangées de surfaces de pastilles, se superposent les marques de repérage de la rangée suivante de surfaces de pastilles et que les marques de repérage soient formées au moyen d'au moins deux expositions.

9. Procédé selon les revendications 7 et 8, caractérisé en ce que les marques de repérage sont reproduites dans la région du masque qui correspond aux lignes de coupe sur la tranche de semi-conducteur.

10. Utilisation de masques munis de marques de repérage qui ont été produits conformément aux revendications 7 à 9 dans un procédé photolithographique pour la production de composants à semi-conducteurs.

## Claims

1. Mask for imaging a pattern composed of several chip fields on a photoresist layer, with at least one alignment mark between at least two adjacent chip fields, characterized in that at the edge of these adjacent chip fields spots for alignment marks are provided which would coincide in an ideal application of the chip field patterns on the mask, and that the alignment mark of the mask is formed by the overlay area of the alignment mark spots provided, and that it thus forms the average of the positioning errors of the chip fields involved.

2. Mask as claimed in claim 1, characterized in that the alignment mark is arranged in that area of the mask which corresponds to the border lines on the semiconductor wafer.

3. Mask as claimed in claims 1 and 2, characterized in that the alignment mark is arranged in the area of the point of intersection of the border line with the middle line of the chip fields.

4. Mask as claimed in claims 1 and 2, characterized in that the alignment mark is arranged in the area of the border lines in the corners of the individual chip fields.

5. Mask as claimed in claims 1 to 4, characterized in that it consists of a mutlitude of identical chip fields.

6. Mask as claimed in any one or several of claims 1 to 5, characterized in that it consists of chromium.

7. Method of making a mask in accordance with any one of claims 1 to 6, characterized in that an original with the pattern of the respective chip field and the alignment marks provided thereon is imaged periodically with n-fold reduction onto a glass plate with a chromium and a photoresist layer, that the photoresist layer is developed and the chromium layer etched off through the photoresist mask.

8. Method as claimed in claim 7, characterized in that the photochemical exposure of the reticle is effected in such a manner that the alignment marks of the one row of chip fields are superimposed by the alignment marks of the following row of chip fields, and that alignment marks are formed as a mean of at least two exposures.

9. Method as claimed in claims 7 and 8, characterized in that the alignment marks are imaged in that area of the mask which corresponds to the border line on the semiconductor wafer.

10. Use of masks with alignment marks made in accordance with claims 7 to 9, in a photolithographic process for making semiconductor components.

**0 055 303**

DIGITALISIERTE
ENTWURFSDATEN

FIG. 1

SOFTWARE

VORRICHTUNG ZUR
MUSTERERZEUGUNG

10 X VORLAGE

STEP UND REPEAT -
KAMERA

1 X MUTTERMASKE

FIG. 2

1

FIG. 3A

FIG. 3 B